(19) **Europäisches Patentamt**
**European Patent Office**
**Office européen des brevets**

(11) **EP 4 022 770 B1**

(12) **EUROPÄISCHE PATENTSCHRIFT**

(45) Veröffentlichungstag und Bekanntmachung des Hinweises auf die Patenterteilung:
**01.01.2025  Patentblatt 2025/01**

(21) Anmeldenummer: **20757296.7**

(22) Anmeldetag: **13.08.2020**

(51) Internationale Patentklassifikation (IPC):
*H03K 17/082* (2006.01)    *H03K 17/16* (2006.01)

(52) Gemeinsame Patentklassifikation (CPC):
**H03K 17/0822; H03K 17/162;** H03K 2217/0027

(86) Internationale Anmeldenummer:
**PCT/EP2020/072789**

(87) Internationale Veröffentlichungsnummer:
**WO 2021/037580 (04.03.2021 Gazette 2021/09)**

(54) **VERFAHREN UND VORRICHTUNG ZUR KURZSCHLUSSDETEKTION DURCH SÄTTIGUNGSERKENNUNG IN LEISTUNGSHALBLEITERSCHALTERN**

METHOD AND DEVICE FOR SHORT-CIRCUIT DETECTION BY SATURATION DETECTION IN POWER SEMICONDUCTOR SWITCHES

PROCÉDÉ ET DISPOSITIF DE DÉTECTION DE COURT-CIRCUIT PAR DÉTECTION DE SATURATION DANS DES INTERRUPTEURS À SEMICONDUCTEUR DE PUISSANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **28.08.2019   DE 102019212889**

(43) Veröffentlichungstag der Anmeldung:
**06.07.2022   Patentblatt 2022/27**

(73) Patentinhaber: **Robert Bosch GmbH
70442 Stuttgart (DE)**

(72) Erfinder:
- **PURCAREA, Calin
  70599 Stuttgart (DE)**
- **FRIESE, Falko
  71638 Ludwigsburg (DE)**
- **MATHAI, Deepa
  70178 Stuttgart (DE)**
- **SCHWEIKER, Daniel
  71638 Ludwigsburg (DE)**

(56) Entgegenhaltungen:
**WO-A1-92/01335     DE-B3- 102015 120 166
US-A- 4 503 480**

**Beschreibung**

Stand der Technik

Leistungselektronische Schaltungen verfügen im Allgemeinen über Leistungshalbleiter, die als Schalter betrieben werden (Leistungshalbleiterschalter). Bei diesen Leistungshalbleiterschaltern handelt es sich meist um Metall-Oxid-Halbleiter-Feldeffekttransistoren (MOSFETs) oder Bipolartransistoren mit isolierten Gate-Elektroden (insulated-gate bipolar transistors, IGBTs). Für die überwiegende Mehrheit der Anwendungen basieren diese MOSFETs und IGBTs auf Silizium (Si).

In vielen Anwendungen, insbesondere bei höheren Leistungen und Reihenschaltungen von Leistungshalbleiterschaltern (z. B. als Halbbrücken), müssen die Leistungshalbleiterschalter vor Kurzschlussströmen, insbesondere vor Halbbrückenkurzschlüssen, geschützt werden. Dazu wird der Laststrom des Leistungshalbleiterschalters direkt oder indirekt gemessen und bei Überschreitung des zulässigen Betriebsbereichs wird der Leistungshalbleiterschalter unabhängig von seinem regulären Ansteuersignal geöffnet, sodass der Kurzschlussstrom unterbrochen wird. Die Kurzschlusserkennung muss vergleichsweise schnell erfolgen, da Leistungshalbleiterschalter aufgrund ihrer geringen thermischen Masse nur über eine begrenzte Kurzschlussfestigkeit verfügen. Die Kurzschlussfestigkeit wird üblicherweise als zulässige Kurzschlussdauer angegeben. Diese beträgt für Industrieanwendungen etwa 10$\mu$s [Mikrosekunden] und für Fahrzeugtraktionsinverter etwa 3$\mu$s. Der Abschaltvorgang eines Kurzschlussstroms dauert in etwa 1-2$\mu$s. Daraus folgt, dass die Kurzschlusserkennung bei Fahrzeugtraktionsinvertern in etwa 1-2$\mu$s erfolgen muss.

Im Wesentlichen sind zwei Kurzschlusserkennungsmethoden bekannt:

- I-Sense
- Desat (desaturation detection, bei IGBTs) bzw. Sat (saturation detection, bei MOSFETs)

Um eine aufwändige Messung des Laststroms des Leistungshalbleiterschalters zu umgehen, zielt die (De)Sat-Erkennung auf die indirekte Messung des Spannungsabfalls über dem Lastpfad des Leistungshalbleiterschalters (IGBT: Kollektor-Emitter-Spannung, MOSFET: Drain-Source-Spannung) ab.

Im eingeschalteten Zustand sollte im Regelbetrieb der Spannungsabfall über dem Leistungshalbleiterschalter möglichst klein sein, um die Leitverluste zu minimieren. Übliche Spannungsabfälle beispielsweise bei 500V-Anwendungen betragen in etwa 1-3V [Volt]. Kurzschlussströme betragen meist ein Vielfaches des regulären Betriebsstroms und führen daher zu deutlich höheren Spannungsabfällen über dem Leistungshalbleiterschalter. Im Kurzschlussfall begrenzt der Leistungshalbleiterschalter oft selbst den Kurzschlussstrom, da der reguläre Betriebsbereich im Leitzustand (z. B. MOSFET: ohmscher Bereich) verlassen wird. Ein IGBT entsättigt in diesem Fall und ein MOSFET sättigt. Daher auch die Namensgebung dieser Kurzschlussdetektionsverfahren: Desat von "desaturation detection" (IGBT) und Sat von "saturation detection" (MOSFET).

Da der Spannungsabfall über einem Leistungshalbleiterschalter im gesperrten Zustand deutlich höher ist als im Leitzustand (z. B. 500V zu 1,5V) und die Kurzschlusserkennung trotz steilflankiger Schaltvorgänge schnell erfolgen soll, wird der Spannungsabfall nicht direkt über einen hochohmigen Spannungsteiler (zzgl. Filter und Messverstärker) gemessen. Stattdessen wird eine indirekte Messung mit Hilfe von Entkopplungsdioden verwendet.

Um den Spannungsabfall über dem Leistungshalbleiterschalter im Leitzustand zu messen, wird über die Entkopplungsdiode ein (kleiner) (Hilfs-)Strom in den Leistungspfad des Leistungshalbleiters eingespeist. Dieser (Hilfs-)Strom wird mittels eines Pull-Up-Widerstands oder einer Stromquellenschaltung aus der positiven (Gatetreiber-)Versorgungsspannung also der Versorgungsspannung des Leistungshalbleiterschalters gespeist. Der Spannungsabfall an der Anode der Entkopplungsdiode entspricht nun dem Spannungsabfall über dem Leistungshalbleiterschalter zzgl. der Flussspannung der Entkopplungsdiode. Das Messsignal kann zusätzlich gefiltert und mittels einer Komparatorschaltung ausgewertet werden.

Übersteigt der Spannungsabfall über dem Leistungshalbleiterschalter einen vorher definierten Grenzwert, wird ein Kurzschlussstrom erkannt und ein entsprechender Abschaltvorgang eingeleitet.

Im gesperrten Zustand fällt eine Spannung über dem Leistungshalbleiterschalter ab, die größer ist als die (Gatetreiber-)Versorgungsspannung. Daher sperrt die Entkopplungsdiode. Eine Kurzschlussüberwachung ist im Sperrzustand somit nicht möglich (aber auch nicht erforderlich). Um eine Aufladung des Eingangsfilters durch den Pull-Up-Widerstand zu verhindern, wird im ausgeschalteten Zustand ein Clamping-Transistor gegen Masse aktiviert.

Die beschriebene Form der Kurzschlusserkennung stellt die häufigste Kurzschlusserkennungsmethode dar und ist in vielen am Markt erhältlichen Gatetreiber-ICs bereits integriert, sodass als externe Beschaltung nur eine Entkopplungsdiode und ein analoges (RC-)Filter notwendig sind.

Die DE 10 2016 212 211 A1 beschreibt eine Kurzschlusserkennung. Es wird eine Vorrichtung zum Abschalten eines einen Kollektor-, Emitter- und Gate-Anschluss aufweisenden bipolaren Transistors offenbart. Die Vorrichtung umfasst eine Spannungserfassungseinheit zum Erfassen einer zwischen dem Gate-Anschluss und dem Emitter-Anschluss abfallenden Gate-Emitter-Spannung, eine mit der Spannungserfassungseinheit verbundene Vergleichseinheit zum Vergleichen der Gate-Emitter-Spannung mit einem vorgegebenen Schwellenwert, wobei die Vergleichseinheit ausgangsseitig ein Auslösesignal bereitstellt, wenn die Gate-Emitter-Spannung größer als der Schwellenwert ist, eine Schaltstatuserfassungseinheit (19) zum Erkennen eines von dem Kollektoranschluss zum Emitter-Anschluss fließenden Laststromes, wobei die Schaltstatuserfassungseinheit bei Erkennung eines Laststroms ausgangsseitig ein Laststromsignal bereitstellt, und eine mit der Schaltstatuserfassungseinheit und der Vergleichseinheit verbundene Steuerungseinheit, die bei gleichzeitigem Erhalt eines Laststromsignals und eines Auslösesignals ein Abschaltsignal zum Abschalten des bipolaren Transistors erzeugt.

Aus den Druckschriften DE 10 2015 120166 und WO 92/01335B3 A1 sind Verfahren und Vorrichtungen zum Betrieb von Leistungshalbleiterschaltern bekannt.

Offenbarung der Erfindung

Die vorliegende Erfindung schafft ein Verfahren zur Kurzschlussdetektion durch Sättigungserkennung in Leistungshalbleiterschaltern gemäß dem unabhängigen Anspruch 1 und eine entsprechende Vorrichtung gemäß dem weitern unabhängigen Anspruch 4. Ausgestaltungen und Weiterbildungen der vorliegenden Erfindung sind Gegenstand der abhängigen Ansprüche.

Die Auslöseschwelle der Komparatorschaltung ist im Allgemeinen bei integrierten (De)Sat-Erkennungen, die in Gatetreiber-ICs integriert sind, fest vorkonfiguriert oder kann von einer Primärseite aus konfiguriert werden. Da die indirekte Messung des Spannungsabfalls über dem Leistungshalbleiter auf einem Stromfluss von der (Gatetreiber-)Versorgungsspannung über die Entkopplungsdiode(n) und den Leistungshalbleiter basiert, können keine Spannungsabfälle über dem Leistungshalbleiter größer als die (Gatetreiber-)Versorgungsspannung gemessen werden.

Die (Gatetreiber-)Versorgungsspannung variiert aufgrund von Toleranzen und Fehlern. Übliche Werte können sein:

- typische Versorgung: 18V
- typische Toleranz: ±1V
- Spannungen im Fehlerfall: 10V..20V

Da die Kurzschlusserkennung eine sicherheitsrelevante Funktion ist, muss sie im gesamten Versorgungsspannungsbereich funktionieren (d.h. auch im Fehlerfall einer Versorgungsspannung). Die Auslöseschwelle der Kurzschlusserkennung muss derart gewählt werden, dass normale Betriebsströme nicht als Kurzschluss erkannt und abgeschaltet werden. Daraus folgt die minimal zulässige Auslöseschwelle (Spannungsabfall über Leistungshalbleiter). Sie hängt von der Applikation und Art sowie Auslegung des Leistungshalbleiters ab. Typische Werte für die minimale Auslöseschwelle können bei IGBT-Anwendungen ca. 3V und bei Verwendung von Wide-Band-Gap-Leistungshalbleitern 10V..15V sein. Eine Kurzschlusserkennung unterhalb der minimalen Auslöseschwelle muss nur in einem eingeschränkten Bereich der Versorgungsspannungen garantiert werden, z.B. im nominalen Versorgungsspannungsbereich (Versorgung ist fehlerfrei).

Die vorliegende Erfindung führt dazu die Auslöseschwelle abhängig von der Versorgungsspannung nach. Insbesondere auch bei großem Versorgungsspannungsbereich, einer hohen minimalen Auslöseschwelle und/oder Wide-Band-Gap-Leistungshalbleitern (SiC, GaN usw.) ist die Kurzschlusserkennung mit der vorliegenden Erfindung möglich.

Gemäß einem ersten Aspekt der vorliegenden Erfindung umfasst ein Verfahren zur Kurzschlussdetektion durch Sättigungserkennung in Leistungshalbleiterschaltern die Schritte Bereitstellen einer Referenzspannung $U_{ref}$, Erzeugen einer Differenzspannung $U_{diff}$, Vergleichen der erzeugten Differenzspannung $U_{diff}$ mit einer vorbestimmten Grenzspannung $U_{lim}$ und Öffnen des Leistungshalbleiterschalters. Im Schritt Bereitstellen der Referenzspannung $U_{ref}$ wird die Referenzspannung $U_{ref}$ in Abhängigkeit einer Versorgungsspannung $U_{VDD}$ eines Leistungshalbleiterschalters bereitgestellt, sodass die Referenzspannung $U_{ref}$ Änderungen in der Versorgungsspannung $U_{VDD}$ folgt. Im Schritt Erzeugen einer Differenzspannung $U_{diff}$ entspricht die Differenzspannung $U_{diff}$ einer Differenz eines Spannungsabfalls $U_{\Delta}$ eines Lastpfads des Leistungshalbleiterschalters und der bereitgestellten Referenzspannung $U_{ref}$. Im Schritt Vergleichen der erzeugten Differenzspannung $U_{diff}$ mit der vorbestimmten Grenzspannung $U_{lim}$ wird ein Kurzschlussstrom in dem Lastpfad des Leistungshalbleiterschalters erkannt, wenn die Differenzspannung $U_{diff}$ die Grenzspannung $U_{lim}$ übersteigt. Im Schritt Öffnen des Leistungshalbleiterschalters wird der Leistungshalbleiterschalter geöffnet, wenn ein Kurzschlussstrom in dem Lastpfad des Leistungshalbleiterschalters erkannt wurde.

Gemäß einem zweiten Aspekt der vorliegenden Erfindung umfasst eine Vorrichtung zur Kurzschlussdetektion durch Sättigungserkennung in Leistungshalbleiterschaltern wenigstens eine Entkopplungsdiode, eine Stromquelle, eine Referenzspannungsquelle, eine Komparatorschaltung und eine Auswerteelektronik. Die wenigstens eine Entkopplungsdiode ist ausgebildet, mit einem Drainanschluss oder einem Kollektoranschluss eines Leistungshalbleiterschalters elektrisch verbunden zu werden. Ein Spannungsabfall $U_{\Delta}$ an einer Anode der wenigstens einen Entkopplungsdiode entspricht einem Spannungsabfall $U_{\Delta}$ eines Lastpfads des Leistungshalbleiterschalters. Die Stromquelle ist mit der wenigstens einen Entkopplungsdiode elektrisch verbunden. Die Stromquelle ist ausgebildet, einen Hilfsstrom in einen Lastpfad des Leistungshalbleiterschalters einzuspeisen, wenn die wenigstens eine Entkopplungsdiode mit dem Drainanschluss oder dem Kollektoranschluss des Leistungshalbleiterschalters elektrisch verbunden ist. Die Referenzspannungsquelle ist ausgebildet, mit einer Versorgungsstromquelle für den Leistungshalbleiterschalter elektrisch verbunden zu werden. Die Referenzspannungsquelle ist ferner ausgebildet, eine Referenzspannung $U_{ref}$ in Abhängigkeit einer Versorgungsspannung $U_{VDD}$ der Versorgungsstromquelle bereitzustellen, sodass die Referenzspannung $U_{ref}$ Änderungen in der Versorgungsspannung $U_{VDD}$ folgt. Die Komparatorschaltung ist mit der wenigstens einen Entkopplungsdiode und der Referenzspannungsquelle elektrisch verbunden. Die Komparatorschaltung ist ausgebildet, eine Differenzspannung $U_{diff}$ zu erzeugen, die einer Differenz des Spannungsabfalls $U_\Delta$ des Lastpfads des Leistungshalbleiterschalters und der bereitgestellten Referenzspannung $U_{ref}$ entspricht. Die Auswerteelektronik ist ausgebildet, die erzeugte Differenzspannung $U_{diff}$ mit einer vorbestimmten Grenzspannung $U_{lim}$ zu vergleichen. Ein Kurzschlussstrom in dem Lastpfad des Leistungshalbleiterschalters wird erkannt, wenn die Differenzspannung $U_{diff}$ die Grenzspannung $U_{lim}$ übersteigt. Die Auswerteelektronik ist ferner ausgebildet, den Leistungshalbleiterschalter zu öffnen, wenn ein Kurzschlussstrom in dem Lastpfad des Leistungshalbleiterschalters erkannt wurde.

Die Referenzspannung $U_{ref}$ ist derart mit der Versorgungsspannung $U_{VDD}$ des Leistungshalbleiterschalters gekoppelt, dass im Falle eines Anstiegs oder Abfalls der Versorgungsspannung $U_{VDD}$, die Referenzspannung $U_{ref}$ ebenfalls entsprechend ansteigt bzw. abfällt. Diese Kopplung der Referenzspannung $U_{ref}$ an die Versorgungsspannung $U_{VDD}$ kann über eine analoge Schaltung erfolgen, sodass die Änderungen der Referenzspannung $U_{ref}$ entsprechend der Versorgungsspannung $U_{VDD}$ hoch dynamisch (im Wesentlichen ohne zeitlichen Unterschied) erfolgen. Die Referenzspannung $U_{ref}$ wird der Versorgungsspannung $U_{VDD}$ somit nachgeführt. Die Versorgungsstromquelle kann beispielsweise Strom mit einer Versorgungsspannung $U_{VDD}$ von 18V bereitstellen.

Die Differenzspannung $U_{diff}$ zwischen dem Spannungsabfall $U_\Delta$ des Lastpfads des Leistungshalbleiters und der Referenzspannung $U_{ref}$ wird erzeugt ($U_{diff}$ = $U_\Delta$ - $U_{ref}$) und mit der vorbestimmten Grenzspannung $U_{lim}$ verglichen. Die vorbestimmte Grenzspannung $U_{lim}$ ist so gewählt, dass sie der mindestens auftretenden Spannung im Kurzschlussfall entspricht, z. B. $U_{lim}$ = 10V..20V. Somit wird, wenn der Spannungsabfall $U_\Delta$ des Lastpfads des Leistungshalbleiters den normalen Betriebsbereich (z. B. 17V..19V) aufgrund eines Kurzschlusses übersteigt (z. B. $U_\Delta$ = 40V), die Differenzspannung $U_{diff}$ ebenfalls ansteigen (z. B. $U_{diff}$ = $U_\Delta$ - $U_{ref}$ = 40V - 18V = 12V). Damit übersteigt die Differenzspannung $U_{diff}$ die vorbestimmte Grenzspannung (z. B. $U_{diff}$ = 10V) und ein Kurzschluss des Leistungshalbleiterschalters wird erkannt. Durch die Nachführung der Referenzspannung $U_{ref}$ kann auch bei dem sehr hohen Spannungsabfall $U_\Delta$ die Auslöseschwelle einer (De)Sat-Erkennung eindeutig erkannt bzw. gemessen werden.

Sofern der Vergleich der Differenzspannung $U_{diff}$ und der vorbestimmten Grenzspannung $U_{lim}$ ergibt, dass die Differenzspannung $U_{diff}$ gleich oder größer als die vorbestimmte Grenzspannung $U_{lim}$ ist, wird ein Kurzschluss erkannt und der Leistungshalbleiterschalter geöffnet. Der Vergleich der Differenzspannung $U_{diff}$ und der vorbestimmten Grenzspannung $U_{lim}$ sowie das Öffnen des Leistungshalbleiterschalters wenn ein Kurzschluss durch den Vergleich erkannt wird, können durch die (De)Sat-Erkennung, die in einer integrierten Schaltung (IC) umgesetzt ist, erfolgen. Die beschriebene Funktionalität kann alternativ auch komplett in einer diskreten (analogen) Schaltung erfolgen.

Da die Auslöseschwelle der (De)Sat-Erkennung durch die nachgeführte Referenzspannung $U_{ref}$ gemäß der vorliegenden Erfindung von der Versorgungsspannung $U_{VDD}$ abhängt, wird ein zusätzlicher Freiheitsgrad beim Schaltungsdesign erreicht. Dieser Freiheitsgrad hat zur Folge, dass eine hohe minimale Auslöseschwelle (in einem eingeschränkten Versorgungsspannungsbereich) erreicht wird und gleichzeitig über den gesamten Versorgungsspannungsbereich hinweg eine Kurzschlusserkennung garantiert werden kann.

Gemäß einer Weiterbildung der vorliegenden Erfindung wird die Referenzspannung $U_{ref}$ zwischen einer Zener-Diode, die mit der Versorgungsstromquelle für den Leistungshalbleiterschalter elektrisch verbunden ist, und einer Parallelschaltung aus einem ersten Widerstand und einem ersten Kondensator, die mit Erde GND elektrisch verbunden ist, bereitgestellt.

Gemäß einer weiteren Weiterbildung der vorliegenden Erfindung umfasst die Referenzspannungsquelle eine Zener-Diode und eine Parallelschaltung aus einem ersten Widerstand und einem ersten Kondensator. Die Referenzspannung $U_{ref}$ wird zwischen der Zener-Diode, die mit der Versorgungsstromquelle für den Leistungshalbleiterschalter elektrisch verbunden ist, und der Parallelschaltung, die mit Erde GND elektrisch verbunden ist, bereitgestellt.

Diese Ausgestaltung der Referenzspannungsquelle bietet eine ausreichend genaue Bereitstellung der Referenzspannung $U_{ref}$ (im Vergleich zu beispielsweise einem bloßen Spannungsteiler) und ist dennoch preiswert (im Vergleich zu beispielsweise einer Präzisions-Referenz).

Gemäß einer Weiterbildung der vorliegenden Erfindung wird der Spannungsabfall $U_\Delta$ des Lastpfads des Leistungshalbleiterschalters an einer Anode wenigstens einer Entkopplungsdiode abgegriffen. Die wenigstens eine Entkopplungsdiode ist mit einem Drainanschluss oder einem Kollektoranschluss des Leistungshalbleiterschalters elektrisch verbunden. Die wenigstens eine Entkopplungsdiode wird durch einen Pull-Up-Widerstand mit dem Hilfsstrom aus einer Stromquelle gespeist.

Der Pull-Up-Wiederstand ermöglicht eine robuste Bereitstellung des Hilfsstroms und ist dennoch preiswert.

Gemäß einer Weiterbildung der vorliegenden Erfindung umfasst die Vorrichtung ferner ein Eingangsfilter, das mit dem Leistungshalbleiterschalter elektrisch parallel geschaltet ist.

Das Eingangsfilter erhöht die Robustheit der Schaltung bzw. Applikation.

Gemäß einer Weiterbildung der vorliegenden Erfindung umfasst das Verfahren ferner den Schritt Verhindern eines Aufladens eines Eingangsfilters. Im Schritt Verhindern des Aufladens des Eingangsfilters wird das Aufladen des Eingangsfilters, das mit dem Leistungshalbleiterschalter elektrisch parallel geschaltet ist, durch den Pull-Up-Wiederstand in einem ausgeschalteten Zustand mittels eines Clamping-Transistors, der mit dem Eingangsfilter elektrisch parallel geschaltet ist, verhindert.

Gemäß einer weiteren Weiterbildung der vorliegenden Erfindung umfasst die Vorrichtung ferner einen Clamping-Transistor. Der Clamping-Transistor ist mit dem Eingangsfilter elektrisch parallel geschaltet. Der Clamping-Transistor ist ausgebildet, ein Aufladen des Eingangsfilters durch den Pull-Up-Wiederstand in einem ausgeschalteten Zustand zu verhindern.

Der Clamping-Transistor ist dazu in dem ausgeschalteten Zustand gegen Erde (GND) geschaltet.

Die Erfindung sowie das technische Umfeld werden nachfolgend anhand der Figuren näher erläutert. Es wird darauf hingewiesen, dass die Erfindung durch die gezeigten Ausführungsbeispiele nicht beschränkt werden soll. Insbesondere ist es, soweit nicht explizit anders dargestellt, auch möglich, Teilaspekte der in den Figuren erläuterten Sachverhalte zu extrahieren und mit anderen Bestandteilen und Erkenntnissen aus der vorliegenden Beschreibung und/oder Figuren zu kombinieren. Insbesondere wird darauf hingewiesen, dass die Figuren und insbesondere die dargestellten Größenverhältnisse nur schematisch sind. Gleiche Bezugszeichen bezeichnen gleiche Gegenstände, so dass ggf. Erläuterungen aus anderen Figuren ergänzend herangezogen werden können.

Fig. 1    zeigt ein schematisches Ablaufdiagramm des Verfahrens zur Kurzschlussdetektion durch Sättigungserkennung in Leistungshalbleiterschaltern.

Fig. 2    zeigt ein schematisches Prinzipschaltbild der Vorrichtung zur Kurzschlussdetektion durch Sättigungserkennung in Leistungshalbleiterschaltern.

Fig. 3    zeigt ein schematisches Ersatzschaltbild einer speziellen Ausführungsform der Vorrichtung aus Fig. 2.

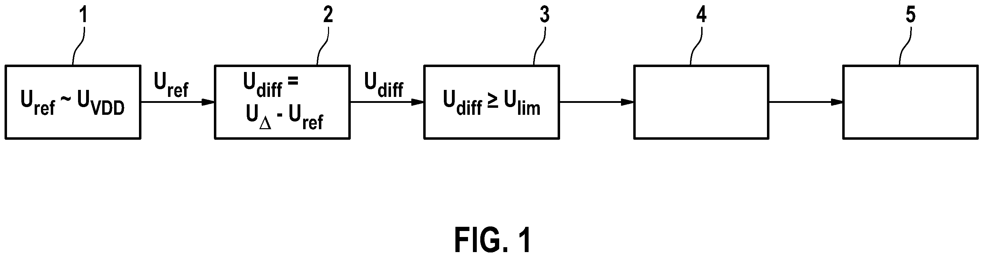

In Fig. 1 ist das Verfahren zur Kurzschlussdetektion durch Sättigungserkennung in Leistungshalbleiterschaltern schematisch dargestellt. Das Verfahren umfasst die Schritte Bereitstellen 1 einer Referenzspannung $U_{ref}$, Erzeugen 2 einer Differenzspannung $U_{diff}$, Vergleichen 3 der erzeugten Differenzspannung $U_{diff}$ mit einer vorbestimmten Grenzspannung $U_{lim}$, Öffnen 4 des Leistungshalbleiterschalters und optional Verhindern 5 eines Aufladens eines Eingangsfilters. Die Schritte des Verfahrens können in beliebiger Reihenfolge und/oder zumindest teilweise gleichzeitig erfolgen.

Im Schritt Bereitstellen 1 der Referenzspannung $U_{ref}$ wird in Abhängigkeit der Versorgungsspannung $U_{VDD}$ des Leistungshalbleiterschalters die Referenzspannung bereitgestellt. Die Referenzspannung $U_{ref}$ folgt dabei Änderungen in der Versorgungsspannung $U_{VDD}$. Dazu wird die Referenzspannung $U_{ref}$ zwischen einer Zener-Diode und einer Parallelschaltung aus einem ersten Widerstand und einem ersten Kondensator bereitgestellt bzw. abgegriffen. Die Zener-Diode ist mit der Versorgungsstromquelle für den Leistungshalbleiterschalter elektrisch verbunden. Die Parallelschaltung aus dem ersten Widerstand und dem ersten Kondensator ist mit Erde GND elektrisch verbunden. Die Versorgungsstromquelle stellt Strom mit einer Versorgungsspannung $U_{VDD}$ von 18V bereit.

$$U_{ref} \sim U_{VDD}$$

Im Schritt Erzeugen 2 der Differenzspannung $U_{diff}$ entspricht die Differenzspannung $U_{diff}$ einer Differenz eines Spannungsabfalls $U_{\Delta}$ eines Lastpfads des Leistungshalbleiterschalters und der bereitgestellten Referenzspannung $U_{ref}$.

$$U_{diff} = U_{\Delta} - U_{ref}$$

Der Spannungsabfall $U_{\Delta}$ des Lastpfads des Leistungshalbleiterschalters wird an einer Anode wenigstens einer Entkopplungsdiode abgegriffen, die mit einem Drainanschluss oder einem Kollektoranschluss des Leistungshalbleiterschalters elektrisch verbunden ist. Die wenigstens eine Entkopplungsdiode wird dabei durch einen Pull-Up-Wiederstand mit dem Hilfsstrom aus einer Stromquelle gespeist.

Im Schritt Vergleichen 3 der erzeugten Differenzspannung $U_{diff}$ mit der vorbestimmten Grenzspannung $U_{lim}$ wird die Differenzspannung $U_{diff}$ mit der vorbestimmten Grenzspannung $U_{lim}$ verglichen. Die Grenzspannung $U_{lim}$ beträgt hier 10V bis 20V. Dabei wird ein Kurzschlussstrom in dem Lastpfad des Leistungshalbleiterschalters erkannt, wenn die Differenzspannung $U_{diff}$ die Grenzspannung $U_{lim}$ erreicht oder übersteigt.

$$U_{diff} \geq U_{lim}$$

Im Schritt Öffnen 4 des Leistungshalbleiterschalters wir der Leistungshalbleiterschalter geöffnet, wenn ein Kurzschlussstrom in dem Lastpfad des Leistungshalbleiterschalters erkannt wurde.

Zudem wird in dem optionalen Schritt Verhindern 5 des Aufladens des Eingangsfilters verhindert, dass das Eingangsfilter durch den Pull-Up-Wiederstand im ausgeschalteten aufgeladen wird. Das Eingangsfilter ist mit dem Leistungshalbleiterschalter elektrisch parallel geschaltet. Durch den Pull-Up-Wiederstand könnte das Eingangsfilter in einem ausgeschalteten Zustand aufgeladen werden. Dies wird durch einen Clamping-Transistor, der mit dem Eingangsfilter elektrisch parallel geschaltet ist, verhindert.

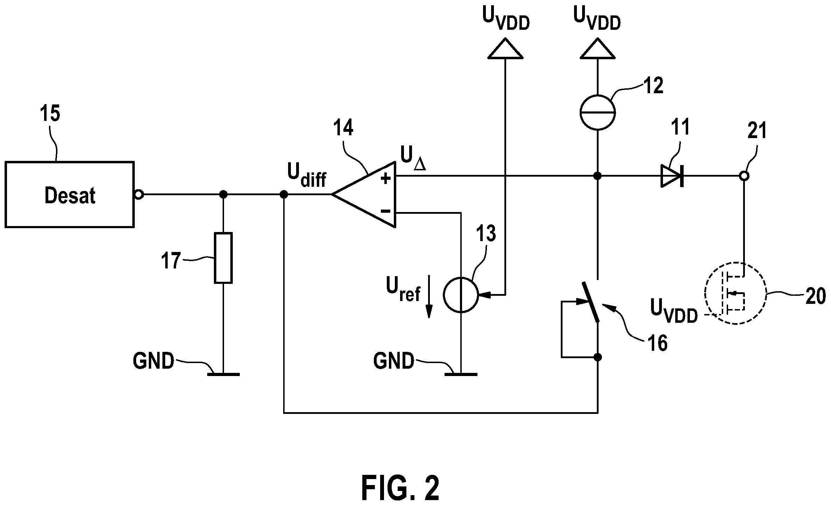

In Fig. 2 ist die Vorrichtung 10 zur Kurzschlussdetektion (Kurzschlusserkennungsschaltung) durch Sättigungserkennung in Leistungshalbleiterschaltern schematisch dargestellt. Die Vorrichtung 10 kann das Verfahren aus Fig. 1 umsetzen.

Die Vorrichtung 10 umfasst folgende Komponenten:

- eine Entkopplungsdiode 11 zu einem Drainanschluss 21 (oder alternativ zu einem Kollektoranschluss (nicht dargestellt)) des Leistungshalbleiters 20;
- eine Stromquelle 12 (in Form eines Pull-Up-Wiederstands, nicht dargestellt);
- eine Referenzspannungsquelle 13 mit Abhängigkeit von einer Versorgungsspannung $U_{VDD}$ des Leistungshalbleiters 20;
- eine Komparatorschaltung 14;
- eine Auswerteelektronik 15;
- ein Clamping-Transistor 16; und
- eine Ausgangsbeschaltung 17.

Die Entkopplungsdiode 11 ist (mit ihrer Anode) elektrisch mit der Stromquelle 12 verbunden und in Flussrichtung ferner mit (ihrer Kathode mit) dem Drainanschluss 21 des Leistungshalbleiterschalters 20 elektrisch verbunden. An der Anode der Entkopplungsdiode 11 wird der Spannungsabfall $U_\Delta$ über dem Lastpfads des Leistungshalbleiterschalters 20 abgegriffen. Die Stromquelle 12 stellt dabei aus der Versorgungsspannung $U_{VDD}$ den Hilfsstrom für die Entkopplungsdiode 11 bereit, damit der Spannungsabfall $U_\Delta$ an der Anode der Entkopplungsdiode 11 gemessen bzw. abgegriffen werden kann.

Die Referenzspannungsquelle 13 stellt die Referenzspannung $U_{ref}$ bereit. Die Referenzspannung $U_{ref}$ folgt einer Versorgungsspannung $U_{VDD}$ der Versorgungsstromquelle des Leistungshalbleiterschalters 20.

Die Entkopplungsdiode 11 (mit ihrer Anode) und die Referenzspannungsquelle 13 sind mit der Komparatorschaltung 14 derart elektrisch verbunden, dass der Ausgang der Komparatorschaltung 14 die Differenzspannung $U_{diff}$ aufweist, wobei die Differenzspannung $U_{diff}$ der Differenz aus Spannungsabfall $U_\Delta$ über dem Lastpfad des Leistungshalbleiterschalters 20 und aus Referenzspannung $U_{ref}$ entspricht.

Die Komparatorschaltung 14 ist mit ihrem Ausgang mit der Auswerteelektronik 15 elektrisch verbunden. Die Auswerteelektronik 15 ist hier eine integriere Schaltung (IC), die das Desat-Verfahren durchführen kann. Dabei wird der Leistungshalbleiterschalter 20 durch die Auswertelektronik/IC 15 geöffnet, wenn die Differenzspannung $U_{diff}$ gleich oder größer als eine vorbestimmte Grenzspannung $U_{lim}$ ist. Dabei ist die vorbestimmte Grenzspannung $U_{lim}$ derart gewählt, dass ein Kurzschluss in dem Leistungshalbleiterschalter 20 vorliegt, wenn die Differenzspannung $U_{diff}$ die vorbestimmte Grenzspannung $U_{lim}$ erreicht oder übersteigt.

Der Clamping-Transistor 16 ist mit dem Ausgang der Komparatorschaltung 14 und der Stromquelle 12 elektrisch verbunden. Dabei verhindert der Clamping-Transistor 16 ein Aufladen eines Eingangsfilters der Vorrichtung 10 durch einen Pull-Up-Wiederstand der Stromquelle 12 in einem ausgeschalteten Zustand.

Zudem ist eine Ausgangsbeschaltung 17 mit dem Ausgang der Komparatorschaltung 14 elektrisch verbunden. Die Ausgangsbeschaltung ist gegen Erde (GND) geschaltet.

Die im Prinzipschaltbild der Vorrichtung 10 dargestellte Funktionalität kann auch in einer (einzigen) integrierten Schaltung (IC) oder komplett in einer diskreten (analogen) Schaltung realisiert werden.

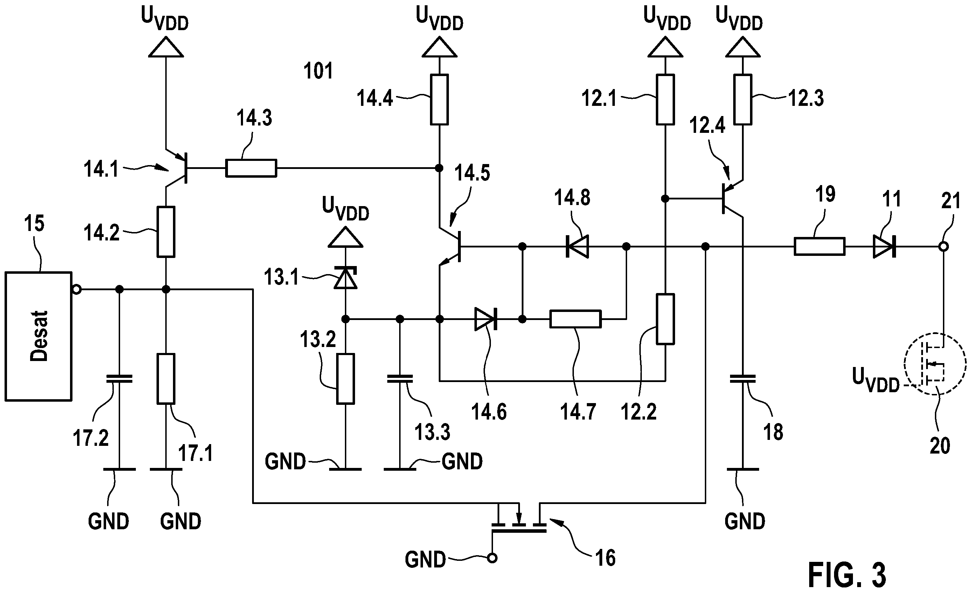

In Fig. 3 ist eine spezielle Ausführungsform der Vorrichtung 10 aus Fig. 2 schematisch dargestellt. Es werden nur Unterschiede bzw. spezielle Ausgestaltungen der Vorrichtung 10 in Fig. 3 zu der Vorrichtung aus Fig. 2 erläutert.

Die Entkopplungsdiode 11 ist mit ihrer Anode über einen Pull-Up-Wiederstand 19 mit der Stromquelle 12 (genauer mit einem Kollektor-Anschluss eines ersten PNP-Transistors 12.4 der Stromquelle 12) elektrisch verbunden.

Die Stromquelle 12 umfasst einen zweiten Wiederstand 12.1 und einen vierten Wiederstand 12.3, die mit der Versorgungsstromquelle des Leistungshalbleiters 20, die die Versorgungsspannung $U_{VDD}$ bereitstellt, elektrisch verbunden sind. Ferner umfasst die Stromquelle einen dritten Wiederstand 12.2, der mit dem ersten Wiederstand 12.1 seriell elektrisch verbunden ist. Zudem umfasst die Stromquelle 12 den ersten PNP-Transistor 12.4, wobei ein Bulk-Anschluss des ersten PNP-Transistors 12.4 zwischen dem ersten Wiederstand 12.1 und dem zweiten Wiederstand 12.2 elektrisch angeschlossen ist, ein Emitter-Anschluss des ersten PNP-Transistors 12.4 mit dem dritten Widerstand 12.3 elektrisch verbunden ist und der Kollektor-Anschluss des ersten PNP-Transistors 12.4 über den Pull-Up-Wiederstand 19 mit der Anode der Entkopplungsdiode 11 elektrisch verbunden ist. Der Kollektor-Anschluss des ersten PNP-Transistors 12.4 ist zudem mit einem dritten Kondensator 18 elektrisch verbunden, wobei der dritte Kondensator 18 zudem gegen Erde (GND) geschaltet ist.

Die Referenzspannungsquelle 13 umfasst eine Zener-Diode 13.1 und eine Parallelschaltung aus einem ersten Wiederstand 13.2 und einem ersten Kondensator 13.3. Die Zener-Diode ist (mit ihrer Kathode) mit der Versorgungsstromquelle des Leistungshalbleiterschalters 20 elektrisch verbunden. Ferner ist die Zener-Diode (mit ihrer Anode) mit der Parallelschaltung elektrisch verbunden. Der erste Wiederstand 13.2 und der erste Kondensator 13.3 der Parallelschaltung sind zudem gegen Erde (GND) geschaltet. Die Zener-Diode 13.1 ist mit ihrer Anode zudem mit der Komparatorschaltung 14 (genauer mit einem Emitter-Anschluss eines NPN-Transistors 14.5 und mit einer Anode einer ersten Diode 14.6 der Komparatorschaltung 14) elektrisch verbunden.

Die Komparatorschaltung 14 umfasst einen zweiten PNP-Transistor 14.1, der mit seinem Emitter-Anschluss mit der Versorgungsstromquelle des Leistungshalbleiterschalters 20, mit seinem Kollektor-Anschluss mit einem fünften Wiederstand 14.2 der Komparatorschaltung 14 und mit seinem Bulk-Anschluss mit einem sechsten Wiederstand 14.3 der Komparatorschaltung 14 elektrisch verbunden ist. Ferner umfasst die Komparatorschaltung 14 den ersten NPN-Transistor 14.5 der mit seinem Kollektor-Anschluss über den sechsten Wiederstand 14.3 mit dem Bulk-Anschluss des zweiten PNP-Transistors elektrisch verbunden ist. Zudem ist der Kollektor-Anschluss des ersten NPN-Transistors 14.5 über einen siebten Wiederstand 14.4 der Komparatorschaltung 14 mit der Versorgungsstromquelle des Leistungshalbleiterschalters 20 elektrisch verbunden. Der Emitter-Anschluss des ersten NPN-Transistors 14.5 ist mit der Anode der Zener-Diode 13.1 der Referenzspannungsquelle 13, der Anode der ersten Diode 14.6 der Komparatorschaltung 14 und mit dem dritten Wiederstand 12.2 der Stromquelle 12 elektrisch verbunden. Ein Bulk-Anschluss des ersten NPN-Transistors 14.5 und eine Kathode der ersten Diode 14.6 sind mit einer Kathode einer zweiten Diode 14.8 der Komparatorschaltung 14 elektrisch verbunden und über einen achten Wiederstand 14.7 der Komparatorschaltung mit dem Kollektor-Anschluss des ersten PNP-Transistors 12.4 der Stromquelle bzw. zusätzlich über den Pull-Up-Wiederstand 19 mit der Anode der Entkopplungsdiode 11 elektrisch verbunden. Der Kollektor-Anschluss des zweiten PNP-Transistors ist über den fünften Wiederstand 14.2 elektrisch mit der Auswerteelektronik 15 verbunden.

Der Clamping-Transistor 16 ist ein N-Kanal Isolierschicht-Feldeffekttransistor der mit seinem Gate-Anschluss gegen Erde (GND) geschaltet ist, sowie einerseits mit seinem Source-Anschluss und seinem Gate-Anschluss mit dem Kollektor-Anschluss des zweiten PNP-Transistors 14.1 der Komparatorschaltung 14 und der Auswerteelektronik 15 und andererseits mit seinem Drain-Anschluss mit dem Kollektor-Anschluss des ersten PNP-Transistors 12.4 der Stromquelle 12 und über den Pull-Up-Wiederstand 19 mit der Anode der Entkopplungsdiode 11 elektrisch verbunden ist.

Die Ausgangsbeschaltung 17 umfasst hier eine Parallelschaltung aus einem neunten Wiederstand 17.1 und einem zweiten Kondensator 17.2. Der neunte Wiederstand 17.1 und der Kondensator sind einerseits mit Erde (GND) und andererseits mit dem Kollektor-Anschluss des zweiten PNP-Transistors 14.1 über den fünften Wiederstand 14.2, der Auswerteelektronik 15 und dem Source-Anschluss und Gate-Anschluss des N-Kanal Isolierschicht-Feldeffekttransistors 16 elektrisch verbunden.

Obwohl hier spezifische Ausführungsformen illustriert und beschrieben wurden, ist für den Fachmann ersichtlich, dass es eine Vielzahl von Alternativen und/oder gleichwertigen Implementierungen gibt. Es ist zu würdigen, dass die exemplarischen Ausgestaltungen oder Ausführungsformen nur Beispiele sind und nicht dazu gedacht sind, den Umfang, die Anwendbarkeit oder die Konfiguration in irgendeiner Weise einzuschränken. Vielmehr wird die vorstehende Zusammenfassung und detaillierte Beschreibung dem Fachmann hinreichende Anweisungen für die Umsetzung von mindestens einer bevorzugten Ausführungsform liefern, wobei es sich versteht, dass verschiedene Änderungen in der Funktion und Anordnung der Elemente, die in einer beispielhaften Ausgestaltung beschrieben werden, nicht von dem in den beigefügten Ansprüchen und ihren rechtlichen äquivalenten dargelegten Anwendungsbereich hinausführen. In der Regel ist diese Anmeldung dazu gedacht, alle Anpassungen oder Variationen der hier diskutierten spezifischen Ausführungsformen abzudecken.

In der vorstehenden ausführlichen Beschreibung wurden verschiedene Merkmale in einem oder mehreren Beispielen zusammengefasst, um die Offenbarung knapp zu halten. Es versteht sich, dass die obige Beschreibung illustrativ und nicht restriktiv sein soll. Sie soll alle Alternativen, Änderungen und äquivalente abdecken, die im Rahmen der Erfindung enthalten sein können. Viele andere Beispiele werden einem Fachmann bei dem Studium der obigen Offenbarung offensichtlich werden.

Um ein umfassendes Verständnis der Erfindung zu ermöglichen, wird eine spezifische Nomenklatur verwendet, die in der vorstehenden Offenbarung verwendet wurde. Es wird jedoch für einen Fachmann im Lichte der darin enthaltenen Spezifikation ersichtlich sein, dass die spezifischen Details nicht erforderlich sind, um die Erfindung zu anzuwenden. So werden die vorstehenden Beschreibungen spezieller Ausführungsformen der vorliegenden Erfindung zu Illustrations-und Beschreibungszwecken dargestellt. Sie sind nicht dazu gedacht, erschöpfend zu sein oder die Erfindung auf die oben offenbarten genauen Ausführungsformen zu beschränken; offensichtlich sind viele Modifikationen und Variationen im Hinblick auf die oben genannten Lehren möglich.

Die Ausführungsformen wurden ausgewählt und beschrieben, um die Grundsätze der Erfindung und ihre praktischen Anwendungen am besten zu erklären und um somit anderen Fachkräften die Möglichkeit zu geben, die Erfindung und verschiedene Ausführungsformen mit verschiedenen Modifikationen, sowie es für die jeweilige Verwendung geeignet erscheint, am besten anzuwenden. In der gesamten Spezifikation werden die Begriffe "einschließlich" und "in welchem/welcher" als Äquivalente der jeweiligen Begriffe "umfassend" bzw. "worin" verwendet. Darüber hinaus werden die Begriffe "erster/erste/erstes", "zweiter/zweite/zweites", "dritter, dritte, drittes" usw. lediglich als Bezeichnung verwendet und sind nicht dazu gedacht, numerische Anforderungen an die Objekte zu stellen oder eine bestimmte Rangfolge vorzugeben. Im Zusammenhang mit der vorliegenden Beschreibung und den Ansprüchen ist die Verbindung "oder" als Aufnahme ("und/oder") zu verstehen und nicht exklusiv ("entweder... oder").

**Patentansprüche**

1.  Verfahren zur Kurzschlussdetektion durch Sättigungserkennung in Leistungshalbleiterschaltern, umfassend die Schritte:

    - Bereitstellen (1) einer Referenzspannung ($U_{ref}$) in Abhängigkeit einer Versorgungsspannung ($U_{VDD}$) eines Leistungshalbleiterschalters (20), sodass die Referenzspannung ($U_{ref}$) Änderungen in der Versorgungsspannung ($U_{VDD}$) folgt;
    - Erzeugen (2) einer Differenzspannung ($U_{diff}$), die einer Differenz eines Spannungsabfalls ($U_\Delta$) eines Lastpfads des Leistungshalbleiterschalters (20) und der bereitgestellten Referenzspannung ($U_{ref}$) entspricht;
    - Vergleichen (3) der erzeugten Differenzspannung ($U_{diff}$) mit einer vorbestimmten Grenzspannung ($U_{lim}$), wobei ein Kurzschlussstrom in dem Lastpfad des Leistungshalbleiterschalters (20) erkannt wird, wenn die Differenzspannung ($U_{diff}$) die Grenzspannung ($U_{lim}$) übersteigt; und
    - Öffnen (4) des Leistungshalbleiterschalters (20), wenn ein Kurzschlussstrom in dem Lastpfad des Leistungshalbleiterschalters (20) erkannt wurde,

    **dadurch gekennzeichnet, dass**
    die Referenzspannung ($U_{ref}$) zwischen einer Zener-Diode (13.1), die mit der Versorgungsstromquelle für den Leistungshalbleiterschalter (20) elektrisch verbunden ist, und einer Parallelschaltung aus einem ersten Widerstand (13.2) und einem ersten Kondensator (13.3), die mit Erde (GND) elektrisch verbunden ist, bereitgestellt wird.

2.  Verfahren gemäß Anspruch 1, wobei der Spannungsabfall ($U_\Delta$) des Lastpfads des Leistungshalbleiterschalters (20) an einer Anode wenigstens einer Entkopplungsdiode (11) abgegriffen wird, die mit einem Drainanschluss oder einem Kollektoranschluss des Leistungshalbleiterschalters (20) elektrisch verbunden ist, wobei die wenigstens eine Entkopplungsdiode (11) durch einen Pull-Up-Widerstand (19) mit einem Hilfsstrom aus einer Stromquelle (12) gespeist wird.

3.  Verfahren gemäß Anspruch 2, ferner umfassend den Schritt:

    - Verhindern (5) eines Aufladens eines Eingangsfilters, das mit dem Leistungshalbleiterschalter (20) elektrisch parallel geschaltet ist, durch den Pull-Up-Wiederstand (19) in einem ausgeschalteten Zustand mittels eines Clamping-Transistors (16), der mit dem Eingangsfilter elektrisch parallel geschaltet ist.

4.  Vorrichtung (10) zur Kurzschlussdetektion durch Sättigungserkennung in Leistungshalbleiterschaltern, umfassend:

    - wenigstens eine Entkopplungsdiode (11), die ausgebildet ist, mit einem Drainanschluss (21) oder einem Kollektoranschluss eines Leistungshalbleiterschalters (20) elektrisch verbunden zu werden, wobei ein Spannungsabfall ($U_\Delta$) an einer Anode der wenigstens einen Entkopplungsdiode (11) einem Spannungsabfall ($U_\Delta$) eines Lastpfads des Leistungshalbleiterschalters (20) entspricht;
    - eine Stromquelle (12), die mit der wenigstens einen Entkopplungsdiode (11) elektrisch verbunden ist und ausgebildet ist, einen Hilfsstrom in einen Lastpfad des Leistungshalbleiterschalters (20) einzuspeisen, wenn die wenigstens eine Entkopplungsdiode (11) mit dem Drainanschluss oder dem Kollektoranschluss des Leistungshalbleiterschalters (20) elektrisch verbunden ist;
    - eine Referenzspannungsquelle (13), die ausgebildet ist, mit einer Versorgungsstromquelle für den Leistungshalbleiterschalter (20) elektrisch verbunden zu werden und eine Referenzspannung ($U_{ref}$) in Abhängigkeit einer Versorgungsspannung ($U_{VDD}$) der Versorgungsstromquelle bereitzustellen, sodass die Referenzspannung ($U_{ref}$) Änderungen in der Versorgungsspannung ($U_{VDD}$) folgt;
    - eine Komparatorschaltung (14), die mit der wenigstens einen Entkopplungsdiode (11) und der Referenzspannungsquelle (13) elektrisch verbunden ist und ausgebildet ist, eine Differenzspannung ($U_{diff}$) zu erzeugen, die einer Differenz des Spannungsabfalls ($U_\Delta$) des Lastpfads des Leistungshalbleiterschalters (20) und der bereitgestellten Referenzspannung ($U_{ref}$) entspricht; und
    - eine Auswerteelektronik (15), die ausgebildet ist, die erzeugte Differenzspannung ($U_{diff}$) mit

einer vorbestimmten Grenzspannung ($U_{lim}$) zu vergleichen, wobei ein Kurzschlussstrom in dem Lastpfad des Leistungshalbleiterschalters (20) erkannt wird, wenn die Differenzspannung ($U_{diff}$) die Grenzspannung ($U_{lim}$) übersteigt, und den Leistungshalbleiterschalter (20) zu öffnen, wenn ein Kurzschlussstrom in dem Lastpfad des Leistungshalbleiterschalters (20) erkannt wurde

**dadurch gekennzeichnet, dass**
die Referenzspannung ($U_{ref}$) zwischen einer Zener-Diode (13.1), die mit der Versorgungsstromquelle für den Leistungshalbleiterschalter (20) elektrisch verbunden ist, und einer Parallelschaltung aus einem ersten Widerstand (13.2) und einem ersten Kondensator (13.3), die mit Erde (GND) elektrisch verbunden ist, bereitgestellt wird.

5. Vorrichtung (10) gemäß Anspruch 4, wobei die wenigstens eine Entkopplungsdiode (11) durch einen Pull-Up-Wiederstand (19) mit dem Hilfsstrom gespeist wird.

6. Vorrichtung (10) gemäß einem der Ansprüche 4 oder 5, ferner umfassend ein Eingangsfilter, das mit dem Leistungshalbleiterschalter (20) elektrisch parallel geschaltet ist.

7. Vorrichtung (10) gemäß Anspruch 6, ferner umfassend einen Clamping-Transistor (16), der mit dem Eingangsfilter elektrisch parallel geschaltet ist und ausgebildet ist, ein Aufladen des Eingangsfilters durch den Pull-Up-Wiederstand (19) in einem ausgeschalteten Zustand zu verhindern.

**Claims**

1. Method for short-circuit detection by saturation detection in power semiconductor switches, comprising the following steps:

    - providing (1) a reference voltage ($U_{ref}$) depending on a supply voltage ($U_{VDD}$) of a power semiconductor switch (20), with the result that the reference voltage ($U_{ref}$) follows changes in the supply voltage ($U_{VDD}$);
    - generating (2) a differential voltage ($U_{diff}$) which corresponds to a difference between a voltage drop ($U_\Delta$) across a load path of the power semiconductor switch (20) and the provided reference voltage ($U_{ref}$);
    - comparing (3) the generated differential voltage ($U_{diff}$) with a predetermined limit voltage ($U_{lim}$), wherein a short-circuit current is detected in the load path of the power semiconductor switch (20) when the differential voltage ($U_{diff}$) exceeds the limit voltage ($U_{lim}$); and

    - opening (4) the power semiconductor switch (20) when a short-circuit current has been detected in the load path of the power semiconductor switch (20),

    **characterized in that**
    the reference voltage ($U_{ref}$) is provided between a Zener diode (13.1), which is electrically connected to the supply current source for the power semiconductor switch (20), and a parallel circuit comprising a first resistor (13.2) and a first capacitor (13.3), which is electrically connected to ground (GND).

2. Method according to Claim 1, wherein the voltage drop ($U_\Delta$) across the load path of the power semiconductor switch (20) is tapped off at an anode of at least one decoupling diode (11), which is electrically connected to a drain terminal or a collector terminal of the power semiconductor switch (20), wherein the at least one decoupling diode (11) is fed an auxiliary current from a current source (12) by means of a pull-up resistor (19).

3. Method according to Claim 2, further comprising the following step:

    - preventing (5) charging of an input filter, which is connected electrically in parallel with the power semiconductor switch (20), by means of the pull-up resistor (19) in a switched-off state by means of a clamping transistor (16), which is connected electrically in parallel with the input filter.

4. Device (10) for short-circuit detection by saturation detection in power semiconductor switches, comprising:

    - at least one decoupling diode (11), which is designed to be electrically connected to a drain terminal (21) or a collector terminal of a power semiconductor switch (20), wherein a voltage drop ($U_\Delta$) across an anode of the at least one decoupling diode (11) corresponds to a voltage drop ($U_\Delta$) across a load path of the power semiconductor switch (20);
    - a current source (12), which is electrically connected to the at least one decoupling diode (11) and is designed to feed an auxiliary current into a load path of the power semiconductor switch (20) when the at least one decoupling diode (11) is electrically connected to the drain terminal or the collector terminal of the power semiconductor switch (20);
    - a reference voltage source (13), which is designed to be electrically connected to a supply current source for the power semiconductor switch (20) and to provide a reference voltage

(U<sub>ref</sub>) depending on a supply voltage (U<sub>VDD</sub>) of the supply current source, with the result that the reference voltage (U<sub>ref</sub>) follows changes in the supply voltage (U<sub>VDD</sub>);

- a comparator circuit (14), which is electrically connected to the at least one decoupling diode (11) and the reference voltage source (13) and is designed to generate a differential voltage (U<sub>diff</sub>), which corresponds to a difference between the voltage drop (U<sub>Δ</sub>) across the load path of the power semiconductor switch (20) and the provided reference voltage (U<sub>ref</sub>); and

- evaluation electronics (15), which are designed to compare the generated differential voltage (U<sub>diff</sub>) with a predetermined limit voltage (U<sub>lim</sub>), wherein a short-circuit current is detected in the load path of the power semiconductor switch (20) when the differential voltage (U<sub>diff</sub>) exceeds the limit voltage (U<sub>lim</sub>), and to open the power semiconductor switch (20) when a short-circuit current has been detected in the load path of the power semiconductor switch (20),

**characterized in that**

the reference voltage (U<sub>ref</sub>) is provided between a Zener diode (13.1), which is electrically connected to the supply current source for the power semiconductor switch (20), and a parallel circuit comprising a first resistor (13.2) and a first capacitor (13.3), which is electrically connected to ground (GND).

**5.** Device (10) according to Claim 4, wherein the at least one decoupling diode (11) is fed the auxiliary current by means of a pull-up resistor (19).

**6.** Device (10) according to either of Claims 4 and 5, further comprising an input filter, which is connected electrically in parallel with the power semiconductor switch (20).

**7.** Device (10) according to Claim 6, further comprising a clamping transistor (16), which is connected electrically in parallel with the input filter and is designed to prevent charging of the input filter by means of the pull-up resistor (19) in a switched-off state.

**Revendications**

**1.** Procédé de détection de court-circuit par reconnaissance de saturation dans des commutateurs à semi-conducteur de puissance, comprenant les étapes consistant à :

- fournir (1) une tension de référence (U<sub>ref</sub>) en fonction d'une tension d'alimentation (U<sub>VDD</sub>) d'un commutateur à semi-conducteur de puissance (20) de sorte que la tension de référence

(U<sub>ref</sub>) suit les variations de la tension d'alimentation (U<sub>VDD</sub>) ;

- générer (2) une tension différentielle (U<sub>diff</sub>) qui correspond à une différence entre une chute de tension (U<sub>Δ</sub>) d'un trajet de charge du commutateur à semi-conducteur de puissance (20) et la tension de référence (U<sub>ref</sub>) fournie ;

- comparer (3) la tension différentielle (U<sub>diff</sub>) générée avec une tension limite (U<sub>lim</sub>) prédéterminée, dans lequel un courant de court-circuit dans le trajet de charge du commutateur à semi-conducteur de puissance (20) est identifié si la tension différentielle (U<sub>diff</sub>) dépasse la tension limite (U<sub>lim</sub>) ; et

- ouvrir (4) le commutateur à semi-conducteur de puissance (20) si un courant de court-circuit dans le trajet de charge du commutateur à semi-conducteur de puissance (20) a été identifié,

**caractérisé en ce que**

la tension de référence (U<sub>ref</sub>) est fournie entre une diode Zener (13.1) qui est reliée électriquement à la source de courant d'alimentation pour le commutateur à semi-conducteur de puissance (20) et un montage parallèle composé d'une première résistance (13.2) et d'un premier condensateur (13.3) et relié électriquement à la terre (GND).

**2.** Procédé selon la revendication 1, dans lequel la chute de tension (U<sub>Δ</sub>) du trajet de charge du commutateur à semi-conducteur de puissance (20) est prélevée au niveau d'une anode d'au moins une diode de découplage (11) qui est reliée électriquement à une borne de drain ou à une borne de collecteur du commutateur à semi-conducteur de puissance (20), dans lequel ladite au moins une diode de découplage (11) est alimentée par l'intermédiaire d'une résistance de rappel (19) par un courant auxiliaire provenant d'une source de courant (12).

**3.** Procédé selon la revendication 2, comprenant en outre l'étape consistant à :

- empêcher (5) une recharge d'un filtre d'entrée qui est monté électriquement en parallèle avec le commutateur à semi-conducteur de puissance (20) par la résistance de rappel (19) dans un état hors tension au moyen d'un transistor d'écrêtage (16) qui est monté électriquement en parallèle avec le filtre d'entrée.

**4.** Dispositif (10) de détection de court-circuit par reconnaissance de saturation dans des commutateurs à semi-conducteur de puissance, comprenant :

- au moins une diode de découplage (11) qui est réalisée pour être reliée électriquement à une borne de drain (21) ou à une borne de collecteur d'un commutateur à semi-conducteur de puissance (20), dans lequel une chute de tension ($U_\Delta$) au niveau d'une anode de ladite au moins une diode de découplage (11) correspond à une chute de tension ($U_\Delta$) d'un trajet de charge du commutateur à semi-conducteur de puissance (20) ;

- une source de courant (12) qui est reliée électriquement à ladite au moins une diode de découplage (11) et est réalisée pour alimenter un courant auxiliaire dans un trajet de charge du commutateur à semi-conducteur de puissance (20) si ladite au moins une diode de découplage (11) est reliée électriquement à la borne de drain ou à la borne de collecteur du commutateur à semi-conducteur de puissance (20) ;

- une source de tension de référence (13) qui est réalisée pour être reliée électriquement à une source de courant d'alimentation pour le commutateur à semi-conducteur de puissance (20) et pour fournir une tension de référence ($U_{ref}$) en fonction d'une tension d'alimentation ($U_{VDD}$) de la source de courant d'alimentation de sorte que la tension de référence ($U_{ref}$) suit les variations de la tension d'alimentation ($U_{VDD}$) ;

- un circuit comparateur (14) qui est relié électriquement à ladite au moins une diode de découplage (11) et à la source de tension de référence (13) et est réalisé pour générer une tension différentielle ($U_{diff}$) qui correspond à une différence entre la chute de tension ($U_\Delta$) du trajet de charge du commutateur à semi-conducteur de puissance (20) et la tension de référence ($U_{ref}$) fournie ; et

- une électronique d'évaluation (15) qui est réalisée pour comparer la tension différentielle ($U_{diff}$) générée avec une tension limite ($U_{lim}$) prédéterminée, dans lequel un courant de court-circuit dans le trajet de charge du commutateur à semi-conducteur de puissance (20) est identifié si la tension différentielle ($U_{diff}$) dépasse la tension limite ($U_{lim}$), et pour ouvrir le commutateur à semi-conducteur de puissance (20) si un courant de court-circuit dans le trajet de charge du commutateur à semi-conducteur de puissance (20) a été identifié,

**caractérisé en ce que**
la tension de référence ($U_{ref}$) est fournie entre une diode Zener (13.1) qui est reliée électriquement à la source de courant d'alimentation pour le commutateur à semi-conducteur de puissance (20) et un montage parallèle composé d'une première résistance (13.2) et d'un premier condensateur (13.3) et relié électriquement à la terre (GND).

5. Dispositif (10) selon la revendication 4, dans lequel ladite au moins une diode de découplage (11) est alimentée par l'intermédiaire d'une résistance de rappel (19) par le courant auxiliaire.

6. Dispositif (10) selon l'une quelconque des revendications 4 ou 5, comprenant en outre un filtre d'entrée qui est monté électriquement en parallèle avec le commutateur à semi-conducteur de puissance (20).

7. Dispositif (10) selon la revendication 6, comprenant en outre un transistor d'écrêtage (16) qui est monté électriquement en parallèle avec le filtre d'entrée et est réalisé pour empêcher une recharge du filtre d'entrée par la résistance de rappel (19) dans un état hors tension.

EP 4 022 770 B1

**FIG. 1**

FIG. 2

FIG. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016212211 A1
- DE 102015120166
- WO 9201335 A1